# EUROPEAN PATENT APPLICATION

(11) **EP 4 332 590 A1**
(43) Date of publication of application: **06.03.2024**
(21) Application number: 23193231.0
(22) Date of filing: 24.08.2023
(51) Int. Cl.: G01R 29/26, H04B 3/00

(54) **NOISE MEASURING DEVICE AND NOISE MEASURING METHOD**

(30) Priority: 30.08.2022 JP 2022137113
(71) Applicant: Espec Corp., Kita-ku Osaka-shi Osaka 530-8550 (JP)
(72) Inventor: KUBOTA, Yoshio, Osaka, 530-8550 (JP); MAKINO, Toshiaki, Osaka, 530-8550 (JP)
(74) Representative: SSM Sandmair

(57) **Abstract**

A noise measuring device includes: communication wiring disposed at a noise measurement target; a transmission unit that transmits a predetermined digital signal to the communication wiring; a reception unit that receives the digital signal from the communication wiring; a detection unit that detects a code error occurring in the digital signal received by the reception unit; and an output unit that outputs information regarding the code error detected by the detection unit.

## Description

### Field of the Invention

The present invention relates to a noise measuring device and a noise measuring method.

### Background Art

For example, JP 2014-66593 A discloses a constant temperature constant humidity device for an environment test according to the background art. As an electric apparatus for adjusting environment in a test chamber, the constant temperature constant humidity device includes a freezer, a heater, a dehumidifier, and a humidifier.

Furthermore, an oscilloscope according to the background art is disclosed in, for example, Japanese Patent No. 2817179.

In an environment forming device such as a constant temperature constant humidity device, when a performance test is performed before shipment or when a failure occurs after shipment, an operator uses a measuring instrument such as an oscilloscope or a noise data logger to perform a work of specifying a spot affected by noise which may cause a defect.

However, since specialist knowledge is required to handle these measuring instruments, applicable operators are limited.

In addition, in order to install probes of these measuring instruments on a measurement target, it is necessary to modify a substrate, change wiring, or the like, and thus, there is a case where a measurable spot is limited in failure analysis or the like of a finished product.

Furthermore, since these measuring instruments are capable of performing only local measurement, it is not possible to efficiently measure a noise influence in a wide range.

### Summary of the Invention

An object of the present invention is to obtain a noise measuring device and a noise measuring method that enable a spot affected by noise to be easily measured without using a measuring instrument such as an oscilloscope and enable a noise influence in a wide range to be efficiently measured with an arbitrary measurement spot as a target.

A noise measuring device according to a first aspect of the present invention includes: communication wiring disposed at a noise measurement target; a transmission unit that transmits a predetermined digital signal to the communication wiring; a reception unit that receives the digital signal from the communication wiring; a detection unit that detects a code error occurring in the digital signal received by the reception unit; and an output unit that outputs information regarding the code error detected by the detection unit.

According to the present aspect, the detection unit detects a code error occurring in the digital signal received by the reception unit, and the output unit outputs information regarding the code error detected by the detection unit. It is accordingly possible to easily measure a spot affected by noise without using a measuring instrument such as an oscilloscope and to efficiently measure a noise influence in a wide range with an arbitrary measurement spot as a target.

A noise measuring device according to a second aspect of the present invention further includes, in the noise measuring device according to the first aspect, a resistance element connected between the communication wiring and the transmission unit.

According to the present aspect, by connecting the resistance element between the communication wiring and the transmission unit, an amplitude of the digital signal can be suppressed, and as a result, a digital signal in which ringing and the like are reduced can be transmitted to the communication wiring to enable improvement in measurement accuracy.

According to a noise measuring device according to a third aspect of the present invention, in the noise measuring device according to the second aspect, the resistance element has a resistance value that is variable.

According to the present aspect, since the resistance value of the resistance element is variable, the amplitude of the digital signal can be adjusted according to desired measurement sensitivity.

A noise measuring device according to a fourth aspect of the present invention further includes, in the noise measuring device according to any one of the first to third aspects, an insulating element connected between the communication wiring and the reception unit.

According to the present aspect, since the insulating element is connected between the communication wiring and the reception unit, it is possible to avoid propagation of noise from a measurement target to the reception unit.

A noise measuring device according to a fifth aspect of the present invention further includes, in the noise measuring device according to any one of the first to fourth aspects, a setting unit that variably sets a frequency of the digital signal to be transmitted by the transmission unit.

According to the present aspect, since the frequency of the digital signal to be transmitted by the transmission unit is variable, the amplitude of the digital signal can be adjusted according to desired measurement sensitivity.

A noise measuring method according to a sixth aspect of the present invention includes: transmitting a predetermined digital signal to communication wiring disposed at a noise measurement target; receiving the digital signal from the communication wiring; detecting a code error occurring in the digital signal received; and outputting information regarding the code error detected.

According to the present aspect, a code error occurring in the received digital signal is detected, and information regarding the detected code error is output. It is accordingly possible to easily measure a spot affected by noise without using a measuring instrument such as an oscilloscope and to efficiently measure a noise influence in a wide range with an arbitrary measurement spot as a target.

### Advantageous Effects of the Invention

According to the present invention, it is possible to easily measure a spot affected by noise without using a measuring instrument such as an oscilloscope and to efficiently measure a noise influence in a wide range with an arbitrary measurement spot as a target.

### Brief Description of the Drawings

Fig. 1 is a diagram illustrating a simplified overall configuration of a noise measuring device according to an embodiment of the present invention.
Fig. 2 is a diagram illustrating a simplified configuration of a communication unit.
Fig. 3 is a view illustrating a situation in which communication wiring is disposed at a noise measurement target.
Fig. 4 is a diagram illustrating a part of a digital signal.

### Description of Embodiments

In the following, an embodiment of the present invention will be described in detail with reference to the accompanying drawings. Note that elements denoted by the same reference numerals in different drawings represent the same or corresponding elements.

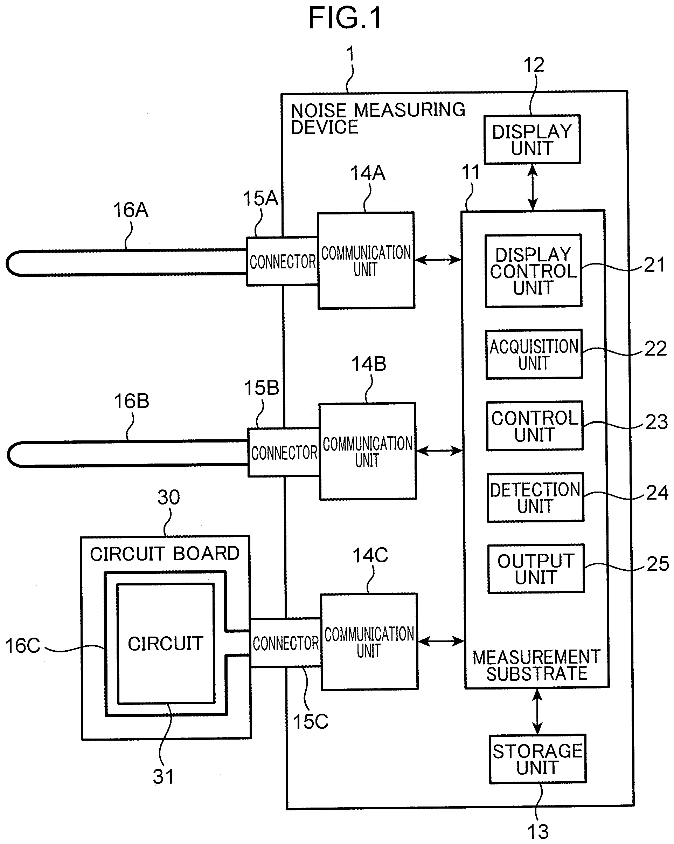

Fig. 1 is a diagram illustrating a simplified overall configuration of a noise measuring device 1 according to an embodiment of the present invention. The noise measuring device 1 includes a measurement substrate 11, a display unit 12, a storage unit 13, a communication unit 14, a connector 15, and communication wiring 16. The noise measuring device 1 may include only one set of the communication unit 14, the connector 15, and the communication wiring 16, or may include a plurality of sets. In a case where a plurality of sets are provided, a communication standard of each set may be the same or may be different as in the following example.

The measurement substrate 11 is configured using a processor such as a CPU. The measurement substrate 11 includes a display control unit 21, an acquisition unit 22, a control unit 23, a detection unit 24, and an output unit 25 as functions implemented by a processor executing a program read from a computer-readable recording medium. Processing contents of each processing unit will be described later.

The display unit 12 is configured using a liquid crystal display, an organic EL display, or the like. Note that configuring the display unit 12 as a touch panel display allows the display unit 12 to serve also as an input unit for a user to input setting information and the like.

The storage unit 13 is configured using an HDD, an SSD, a semiconductor memory, or the like. Note that the storage unit 13 may be configured using a removable recording medium such as an SD card.

The communication unit 14 is configured using a communication module adaptable to a predetermined communication standard. In the example of the present embodiment, the noise measuring device 1 includes a plurality (three in this example) of communication units 14A to 14C. For example, the communication unit 14A supports the communication standard of the RS-232C, the communication unit 14B supports the communication standard of the RS-485, and the communication unit 14C supports the communication standard of the UART. Accordingly, the communication standard for use in noise measurement processing using the noise measuring device 1 can be switched by selection of the communication units 14A to 14C.

The communication unit 14A is connected to the connector 15A, and the connector 15A is connected to the communication wiring 16A. The communication wiring 16A is a communication cable adaptable to the communication standard (e.g., RS-232C) of the communication unit 14A.

The communication unit 14B is connected to the connector 15B, and the connector 15B is connected to the communication wiring 16B. The communication wiring 16B is, for example, a communication cable adaptable to the communication standard (e.g., RS-485) of the communication unit 14B. Since the RS-232C is more susceptible to noise than the RS -485, the noise measurement using the communication wiring 16A has higher measurement sensitivity than the noise measurement using the communication wiring 16B.

The communication unit 14C is connected to the connector 15C, and the connector 15C is connected to the communication wiring 16C. The communication wiring 16C is, for example, a communication circuit adaptable to the communication standard (e.g., UART) of the communication unit 14C, and is formed on a circuit board 30. A circuit 31 as a noise measurement target is formed on the circuit board 30, and the communication wiring 16C is formed to surround a periphery of the circuit 31.

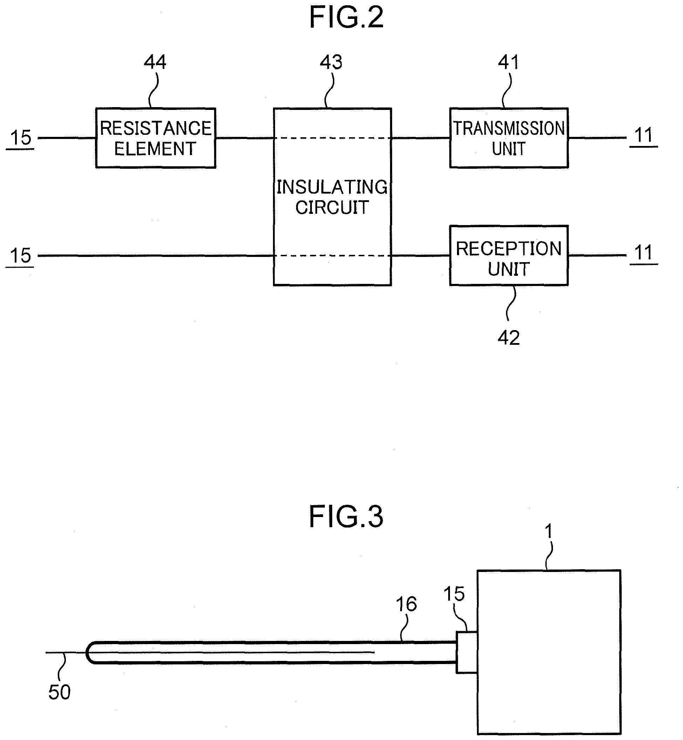

Fig. 2 is a diagram illustrating a simplified configuration of the communication unit 14. The communication unit 14 includes a transmission unit 41, a reception unit 42, an insulating circuit 43, and a resistance element 44. The transmission unit 41 transmits a predetermined digital signal to the communication wiring 16 via the insulating circuit 43, the resistance element 44, and the connector 15. The reception unit 42 receives the digital signal from the communication wiring 16 via the connector 15 and the insulating circuit 43. In other words, the communication wiring 16 is annularly connected to the communication unit 14, and the digital signal transmitted by the transmission unit 41 is received by the reception unit 42 via the communication wiring 16. The digital signal is, for example, a pulse train in which 0 and 1 of binary logic are alternately repeated by a predetermined number of bytes. The resistance element 44 is a variable resistor whose resistance value can be digitally changed. The insulating circuit 43 is configured using, for example, a photocoupler, and electrically insulates the communication wiring 16 from the transmission unit 41 and the reception unit 42.

Fig. 3 is a view illustrating a situation in which the communication wiring 16 is disposed at a noise measurement target 50. The measurement target 50 is a measurement spot that is considered to be affected by noise among electric apparatuses as noise measurement targets. The electric apparatus is, for example, a component of an environment forming device such as an environment testing device or a heat treatment device. Electric apparatuses may be affected by various noises. Noise may cause a failure or a defect of the environment forming device. The noise includes high frequency noise that comes out as a radio wave, low frequency noise mixed from a power supply line or the like, single noise generated due to static electricity, or the like. The communication wiring 16 has a length of about several meters, and is mounted in parallel with or wound around, e.g., a power supply line, which is the measurement target 50 along an extending direction of the measurement target 50 by an operator. Note that the communication wiring 16 may be mounted in parallel with or wound around a device such as a switching power supply or an inverter in addition to wiring such as a power supply line.

The noise measurement processing using the noise measuring device 1 is performed, for example, during execution of an environment test on an object by an environment testing device.

Description will be made with reference to Fig. 1. The acquisition unit 22 acquires various types of information input to the measurement substrate 11 from the outside of the noise measuring device 1 via a digital communication port (not illustrated) such as a LAN port. The information acquired by the acquisition unit 22 includes operation information indicating an operation status of the environment testing device. The operation information includes, for example, information indicating a drive status (e.g., ON or OFF) of each of a plurality of electric apparatuses constituting the environment testing device. In addition, the operation information includes information indicating a drive status of each of a plurality of measuring apparatuses (a temperature sensor, a humidity sensor, a pressure sensor, or the like) included in the environment testing device or information indicating a measurement result (e.g., a temperature value, a humidity value, or a pressure value) of each of the plurality of measuring apparatuses. Note that the acquisition unit 22 may acquire various types of information input via an analog communication port (not illustrated) of the noise measuring device 1 instead of the digital communication port described above.

The detection unit 24 detects a code error occurring in the digital signal received by the reception unit 42. The detection unit 24 detects, for example, an instantaneous value and an accumulated value of a code error, and outputs the instantaneous value and the accumulated value as a noise detection result. Since a data content (i.e., a bit configuration) of the digital signal to be transmitted by the transmission unit 41 is known, the detection unit 24 can detect a code error by comparison with the known data content. As a code error detection method, a well-known error detection method such as a parity bit method, a checksum method, or a CRC method can be used.

The control unit 23 controls the communication unit 14 and the storage unit 13, and sets various types of information regarding the noise measurement. The control unit 23 stores the operation information acquired by the acquisition unit 22 and the noise detection result obtained by the detection unit 24 in the storage unit 13 in association with each other. The control unit 23 may further store information indicating a noise measurement condition such as a noise measurement spot input by the operator in the storage unit 13 in association with the operation information. In addition, the control unit 23 sets at least one of a frequency of the digital signal to be transmitted by the transmission unit 41, an amplitude of the digital signal, and a resistance value of the resistance element 44 according to a desired value of the measurement sensitivity input by the operator.

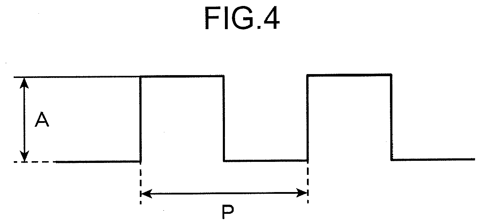

Fig. 4 is a diagram illustrating a part of the digital signal to be transmitted by the transmission unit 41. The control unit 23 sets the frequency (in other words, a cycle P) of the digital signal to be transmitted by the transmission unit 41 and/or an amplitude A of the digital signal. The control unit 23 adjusts the cycle P and/or the amplitude A of the digital signal by inputting the setting information to the transmission unit 41. The shorter the cycle P, the higher the measurement sensitivity, and the smaller the amplitude A, the higher the measurement sensitivity. Furthermore, the control unit 23 adjusts the resistance value of the resistance element 44 by setting the resistance value of the resistance element 44 and inputting the setting information to the resistance element 44. Since the higher the resistance value of the resistance element 44, the smaller the amplitude A of the digital signal to be transmitted to the communication wiring 16, the measurement sensitivity is high.

The output unit 25 outputs information indicating a noise measurement result detected by the detection unit 24. This information is input from the output unit 25 to the display control unit 21. The display control unit 21 generates image data indicating the noise measurement result and inputs the image data to the display unit 12. As a result, an image indicating the noise measurement result is displayed on the display unit 12.

According to the present embodiment, the communication wiring 16 is mounted in parallel with or wound around the measurement target 50 in a wide range along the extending direction thereof, unlike noise measurement using an oscilloscope in which a probe is locally brought into contact with the measurement target 50. Then, the detection unit 24 detects a code error occurring in the digital signal received by the reception unit 42, and the output unit 25 outputs information (noise measurement result) regarding the code error detected by the detection unit 24. It is accordingly possible to easily measure a spot affected by noise without using a measuring instrument such as an oscilloscope and to efficiently measure a noise influence in a wide range with an arbitrary measurement spot as a target. In addition, since it is only necessary to mount or wind the communication wiring 16 in parallel with or around the measurement target 50, and it is not necessary to modify a substrate, change wiring, or the like for bringing the probe into contact with the measurement target 50, which is required for an oscilloscope or the like, it is possible to simplify the noise measurement work.

Furthermore, according to the present embodiment, the amplitude of the digital signal can be suppressed by connecting the resistance element 44 between the communication wiring 16 and the transmission unit 41. As a result, the digital signal in which ringing and the like are reduced can be transmitted to the communication wiring 16 to enable improvement in measurement accuracy.

Furthermore, according to the present embodiment, since the resistance value of the resistance element 44 is variable, the amplitude of the digital signal can be adjusted according to the desired measurement sensitivity.

In addition, according to the present embodiment, since the insulating circuit 43 is connected between the communication wiring 16 and the reception unit 42, it is possible to avoid propagation of noise from the measurement target to the reception unit 42.

Furthermore, according to the present embodiment, since the frequency of the digital signal to be transmitted by the transmission unit 41 is variable, the amplitude of the digital signal can be adjusted according to the desired measurement sensitivity.

## Claims

1. A noise measuring device comprising:
communication wiring disposed at a noise measurement target;
a transmission unit that transmits a predetermined digital signal to the communication wiring;
a reception unit that receives the digital signal from the communication wiring;
a detection unit that detects a code error occurring in the digital signal received by the reception unit; and
an output unit that outputs information regarding the code error detected by the detection unit.

2. The noise measuring device according to claim 1, further comprising a resistance element connected between the communication wiring and the transmission unit.

3. The noise measuring device according to claim 2, wherein the resistance element has a resistance value that is variable.

4. The noise measuring device according to claim 1, further comprising an insulating circuit connected between the communication wiring and the reception unit.

5. The noise measuring device according to claim 1, further comprising a control unit that variably sets a frequency of the digital signal to be transmitted by the transmission unit.

6. A noise measuring method comprising:
transmitting a predetermined digital signal to communication wiring disposed at a noise measurement target;
receiving the digital signal from the communication wiring;
detecting a code error occurring in the digital signal received; and
outputting information regarding the code error detected.
